Europäisches Patentamt

European Patent Office

Office européen des brevets

(11) Veröffentlichungsnummer: **0 097 201**
**B1**

(12) **EUROPÄISCHE PATENTSCHRIFT**

(45) Veröffentlichungstag der Patentschrift:
03.06.87

(51) Int. Cl.⁴: **H 03 G  3/30,** H 03 G  3/20

(21) Anmeldenummer: **82105485.5**

(22) Anmeldetag: **22.06.82**

(54) Frequenzselektiver geregelter elektronischer Verstärkerstromkreis.

(43) Veröffentlichungstag der Anmeldung:
**04.01.84 Patentblatt 84/1**

(45) Bekanntmachung des Hinweises auf die Patenterteilung:
**03.06.87 Patentblatt 87/23**

(84) Benannte Vertragsstaaten:
**AT BE CH DE FR GB IT LI LU NL SE**

(56) Entgegenhaltungen:
**CH - A - 559 472**
**FR - A - 1 302 631**
**FR - A - 1 381 174**
**FR - A - 2 233 749**
**FR - A - 2 282 745**
**GB - A - 875 169**
**US - A - 2 773 945**

(73) Patentinhaber: **TELEFONGYAR, Hungária körut 126-132, H-1143 Budapest (HU)**

(72) Erfinder: **Nyéki, István, Bajcsy-Zsilinszky telep B/III épület, H-6900 Makó (HU)**
Erfinder: **Boglár, Gyula, Frankel leó ut 106, H-1023 Budapest (HU)**

(74) Vertreter: **Kern, Wolfgang Dipl.-Ing. et al, Patentanwälte Tischer, Kern & Brehm Albert-Rosshaupter-Strasse 65, D-8000 München 70 (DE)**

# Beschreibung

Die Erfindung betrifft einen aus einer oder mehreren Stufen bestehenden, frequenzselektiven, geregelten, elektronischen Verstärkerstromkreis, dessen Ausgang je Stufe von dem Ausgang eines in den Kollektorkreis eines Transistors geschalteten Bandfilters gebildet ist, während das Regelorgan je Stufe mit der Impedanz des Emitterkreises des Transistors gekoppelt ist, wobei die Impedanz des Emitterkreises ein frequenzabhängiges Element enthält, das mit einem spannungsgesteuerten Widerstand parallelgeschaltet ist.

Bei einem derartigen elektronischen Verstärkerstromkreis (FR-A-2 233 749) erfolgt die Spannungsregelung mit einer zur Ausgangsspannung proportionalen Spannung und durch den Verstärkertransistor fliesst mit zunehmender Ausgangsspannung ein steigender Strom, so dass der Transistor nicht sperrt und in einen ungesättigten Schaltbetrieb übergeht. Dadurch ist der Wirkungsgrad des bekannten Verstärkerstromkreises entsprechend gering und somit auch seine Anwendungsmöglichkeit, beispielsweise für Frequenzvervielfachung, sehr beschränkt.

Aus dem Stand der Technik ist ferner ein pegelbegrenzender Stromkreis bekannt, bei dem aus dem zu verarbeitenden Signal ein Rechtecksignal erzeugt und die Grundfrequenz ausgefiltert wird. Bei einer derartigen Verarbeitung aber hängt die Amplitude des Nutzsignals von dem Verhältnis Signal/Pause und der Grunddämpfung des Filters ab; die Bedeutung wird noch dadurch erhöht, dass diese Charakteristiken sich in Abhängigkeit von der Zeit und äusseren Parametern auch voneinander unabhängig verändern. Die erwähnten Nachteile können auch bei jenen bekannten Lösungen beobachtet werden, bei denen eine Begrenzung mit Dioden und eine darauffolgende Filterung verwendet wird.

Eine Pegelbegrenzung ist oft auch bei solchen Verstärkern erforderlich, deren wichtigste Bestimmung nicht eben in der Pegelbegrenzung besteht. In solchen Fällen wird häufig eine Regelschleife mit Folgecharakter ausgestaltet. Derartige geregelte Verstärkerstromkreise werden im allgemeinen für eine gewisse Bestimmung entwickelt, um die Beherrschung mehrerer spezifizierten Parameter unter günstigen Bedingungen sicherstellen zu können; daher ist ihr Anwendungskreis recht beschränkt. Wird dagegen eine Gestaltung für allgemeine Zwecke erzielt, ist der Aufbau kompliziert. Der Eingriff findet meistens bei dem das zu verarbeitende Signal empfangenden Eingang oder in dem dem Eingang vorgeschalteten Stromkreiszweig statt, wodurch der regelnde Eingriff bereits in Form des zu verarbeitenden Eingangssignals beeinflusst.

Die Aufgabe der Erfindung besteht deshalb darin, einen aus wenigen Elementen aufgebauten, eine einfache Konstruktion aufweisenden und daher verhältnismässig billigen, trotzdem aber betriebssicheren, zur allgemeinen Verwendung geeigneten, dabei auch die Pegelbegrenzung sicherstellenden Verstärkerstromkreis zu entwikkeln, der entweder aus diskreten Elementen oder als integrierter Dick- bzw. Dünnschicht-Stromkreis aufgebaut werden kann, und bei dem die Ausgangssignalspannung, die Amplitude des Ausgangssignals ausschliesslich von dem dem gewünschten Nennwert gemäss gewähltem Pegel der Referenzspannung abhängt, wodurch eine hochgradige Amplitudenstabilität realisiert werden kann.

Diese Aufgabe wird erfindungsgemäss dadurch gelöst, dass das frequenzabhängige Element ein bei Nullfrequenz einen Pol aufweisendes Glied, vorzugsweise ein Kondensator oder ein in Reihe geschaltetes RC-Glied ist, das der Stromkreis einen Referenzgeber und einen Vergleicherzweig enthält, in dem ein mit dem Ausgang des Bandfilters gekoppelter Signalgeber, ein Ventilwirkung entfaltender Widerstand und ein Kondensator in Reihe geschaltet sind, wobei die eine Klemme des Vergleicherzweiges an den Ausgang des Referenzgebers angeschlossen ist, während die gemeinsame Klemme des Widerstandes und des Kondensators an die Steuerklemme des spannungsgesteuerten Widerstandes angeschlossen ist.

Die Erfindung beruht auf der Erkenntnis, dass dann, wenn die Komparation der Gleichstromspannung mit dem Betrieb des aktiven Elements – das als ein Verstärker der Klasse C funktioniert – kombiniert wird und der zu der Klasse C gehörende Verstärker mit Abstimmkreis mit dem Ausgangssignal des Komparators gesteuert wird, der so ausgestaltete Stromkreis in einem mit dem Verbrauch in Einklang gebrachten Betrieb die Funktion der Pegelbegrenzung bzw. der Regelung ausüben kann, da sowohl die Frequenz wie auch die Amplitude des Steuersignals und der Arbeitspunkt des Belastungswiderstands in diesem Mechanismus koordiniert geregelt werden.

Der zwecks Realisierung dieser Erkenntnis geschaffene erfindungsgemässe Verstärkerstromkreis kann ein- oder mehrstufig ausgestaltet sein, wobei jede Stufe frequenzselektiv ist und in einem geregelten Betrieb arbeitet. Bei einem mehrstufigen Stromkreis enthält jede einzelne Stufe einen Transistor als aktives Element, in dessen Kollektorkreis ein Bandfilter angeordnet ist. Der Ausgang des Stromkreises bzw. der Stufe wird von dem Ausgang des Bandfilters gebildet. Das je Stufe vorhandene Regelorgan ist mit der Impedanz des Emitterkreises des Transistors gekoppelt.

Bei einem vorteilhaften Ausführungsbeispiel wird der Referenzgeber von einem zwischen den Klemmen der Speisespannungsquelle geschalteten, die Reihenschaltung eines Widerstands und eines spannungsstabilisierenden Elements, zweckmässig einer Zenerdiode enthaltenden Stromkreiszweig und von einem mit dem spannungsstabilisierenden Element parallel geschalteten Spannungsteiler mit veränderlichem Teilungsverhältnis gebildet, wobei die Abzweigung des Spannungsteilers den Ausgang des Referenzgebers bildet.

Bei einer weiteren Ausführungsform verfügt der Referenzgeber über ein zur periodischen Infrafrequenz-Veränderung des Ausgangspegels geeignetes Mittel. In der Beschreibung wird unter dem Ausdruck ‹Infrafrequenz-Periodizität› nicht nur eine Periodizität mit einer 1 Hz unterschreitenden Frequenz verstanden, sondern auch die periodische Änderung, deren Wiederholungsfrequenz zwar grösser ist als 1 Hz, aber gegenüber der kleinsten Betriebsfrequenz des Verstärkers um soviel niedriger ist, z.B. um drei Grössenordnungen, dass, mit der Frequenz des nützlichen Ausgangssignals des Verstärkerstromkreises verglichen, das Referenzsignal praktisch als einen konstanten Wert aufweisendes Signal betrachtet werden kann, insbesodere deshalb, da die mit dem Referenzsignal aufeinanderfolgend zu vergleichenden Hochfrequenz-Sinuswellen auf einen annähernd gleichen Referenzpegel superponiert werden.

In einem in diesem Sinne infrafrequenzmodulierten Ausgangssignal ist daher das Infrafrequenz-Referenzsignal als ein Wechselstrom-Modulationssignal vorhanden, wobei in dem Komparatorzweig dieses Referenzsignal trotzdem die Rolle eines Gleichstrom-Grundsignals spielt.

Zweckmässigerweise ist der spannungsgesteuerte Widerstand ein Stromgenerator mit einem mit einer Spannung steuerbaren Arbeitspunkt. Der Leitsignalgeber kann vorteilhaft realisiert werden, wenn der Ausgang des Bandfilters induktiv gekoppelt ist. Unter Anwendung einer geeigneten Übersetzung kann er von einer mit dem Ausgang gekoppelten induktiven Wicklung gebildet werden. Falls jedoch bei einer mehrstufigen Ausführung z.B. die Kopplung zwischen den Stufen nicht induktiv, sondern galvanisch ist, kann auch dann der Leitsignalgeber als eine mit der induktiven Wicklung des Bandfilters gekoppelte induktive Wicklung ausgestaltet werden.

Auf vielen Anwendungsgebieten kann lediglich durch die richtige Dimensionierung und geeignete Verbindung der obenerwähnten wesentlichen Bestandteile ein betriebsfähiger Verstärkerstromkreis aufgebaut werden. Gleichzeitig aber kann der Stromkreis mit zahlreichen weiteren funktionellen Elementen zur Erfüllung besonderer Aufgaben und zwecks Erreichens zusätzlicher Wirkungen ergänzt werden.

Die Erfindung wird anhand einiger vorteilhafter Ausführungsbeispiele, mit Hilfe der beiliegenden Zeichnungen näher erläutert. Es zeigen:

Figur 1 den Grundaufbau des erfindungsgemässen Verstärkerstromkreises in einem Blockschema,

Figur 2 das funktionelle Schema der darin ausgestalteten Regelschleife,

Figur 3 die Ausgestaltung des spannungsgesteuerten Widerstandes mit Stromgenerator,

Figur 4 die Verwendung als Frequenzmultiplikator,

Figur 5 die Verwendung als ein Redundanzstromkreis zur Erhöhung der Zuverlässigkeit,

Figur 6 die Verwendung als LC-Oszillator,

Figur 7 und 8 zeigen die Einzelheiten je eines Ausführungsbeispiels des erfindungsgemässen pegelstabilisierenden Stromkreises.

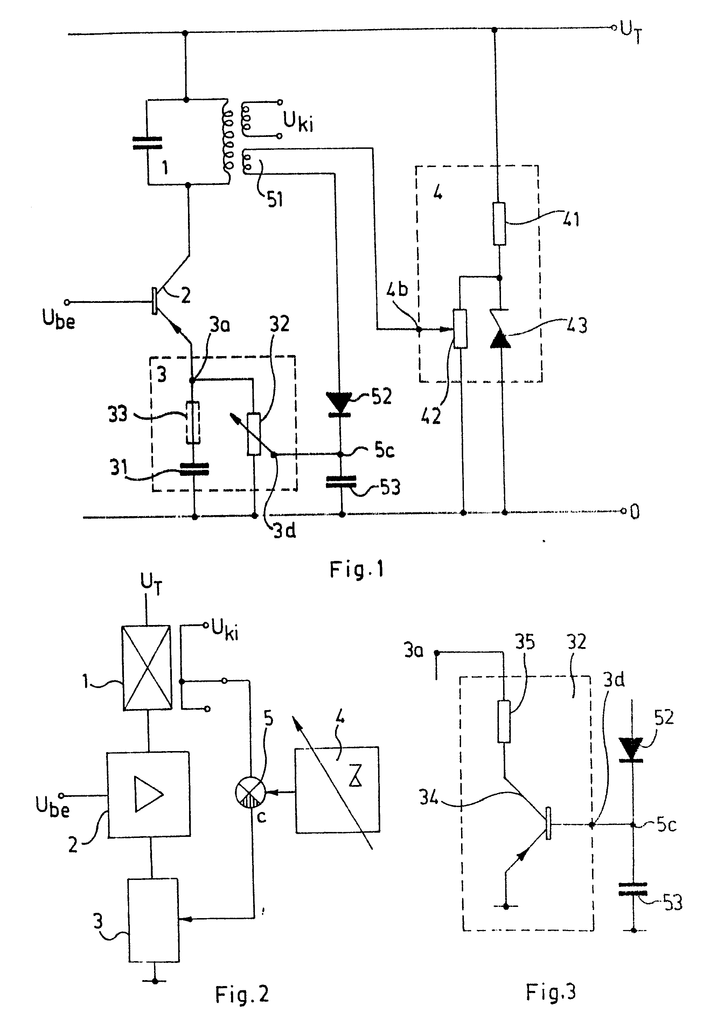

Wie es aus der Figur 1 ersichtlich ist, ist das aktive Element des Verstärkerstromkreises ein Transistor 2, an dessen Basis die Eingangsspannung $U_{be}$ angelegt wird, wobei die Ausgangsspannung $U_{ki}$ von dem Bandfilter 1 des Kollektorkreises abgekoppelt wird. Bei der dargestellten Ausführung ist die Entkoppelung induktiv. In dem Emitterkreis des Transistors 2 ist mit einer frequenzabhängigen Impedanz ein spannungsgesteuerter Widerstand parallel geschaltet. Aus der Figur ist ersichtlich, dass der spannungsgesteuerte Widerstand 32 unter allen Umständen mit dem Kondensator 31 parallel geschaltet ist, wobei häufig diese zwei Stromkreiselemente an sich die Impedanz 3 des Emitterkreises bilden. Überdies kann ein weiterer Widerstand 33 eingesetzt werden. In den einen Stromkreiszweig eingefügt (mit gestrichelter Linie dargestellt) bildet der Widerstand 33 mit dem Kondensator 31 ein RC-Glied; aber dieses kann unmittelbar mit der Emitterelektrode in Reihe geschaltet werden. In diesem Fall schliessen sich an die untere Klemme des Widerstands 33 zwei parallele Zweige an, von denen der eine den Kondensator 31, der andere den spannungsgesteuerten Widerstand 32 enthält, während die gemeinsame Klemme der beiden Zweige an den zwischen der Emitterelektrode und dem gemeinsamen Punkt 3a eingefügten Widerstand 33 anschliesst. Zwischen der Klemme $U_T$ der Speisespannungsquelle und dem O-Punkt des Stromkreises mit dem gemeinsamen Potential ist der den Widerstand 41 und die Zener-Diode 43 enthaltende Stromkreiszweig eingeschaltet; dieser Zweig und der mit einer Zenerdiode 43 parallel geschaltete Spannungsteiler 42 mit einem veränderlichen Teilungsverhältnis bilden den Referenzgeber 4, dessen Ausgang 4b bei diesem Beispiel von der Abzweigung des Spannungsteiler 42 gebildet ist. In der weiteren zwischen dem Referenzgeber 4 und dem O-Punkt des Stromkreises mit gemeinsamem Potential eingeschalteten Abzweigung des Stromkreises sind, von dem Referenzgeber 4 ausgehend, der Reihe nach ein Leitsignalgeber 51, ein Widerstand 52 mit Ventilwirkung und ein Kondensator 53 in Reihe geschaltet. Bei diesem Ausführungsbeispiel wird der Leitsignalgeber 51 durch eine mit der induktiven Wicklung des Bandfilters 1 gekoppelte induktive Wicklung gebildet, während der Widerstand 52 mit Ventilwirkung zweckmässigerweise eine Halbleiterdiode ist.

In der Figur 2 kann der Ablauf der Regelung verfolgt werden. Von dem Ausgang 4b des Referenzgebers 4 gelangt das dem gewünschten Signalpegel entsprechend gewählte Grundsignal zum Eingang der differenzbildenden Einheit 5, in der es mit der Gleichstromkomponente der durch den Leitsignalgeber 51 gelieferten und durch den Widerstand 52 mit Ventilwirkung gewonnenen Wechselspannung verglichen wird. Der Ausgang der differenzbildenden Einheit 5 wird von der Klemme 5c gebildet. Die eine mit der induktiven Wicklung des Bandfilters 1 gekoppelte Wicklung liefert die vollständige Spannung $U_{ki}$, während die

andere Wicklung mit einer abweichenden Übersetzung die Spannung mit dem Pegel k.$U_{ki}$ liefert, wo k = 1. Auf diese Weise wird das an dem Referenzgeber 4 eingestellte Grundsignal immer mit einem mit der Ausgangsspannung $U_{ki}$ proportionalen Leitsignal verglichen.

Der spannungsgesteuerte Widerstand 32 wird zweckmässigerweise als ein mit Spannung steuerbarer Stromgenerator ausgestaltet, z. B. so wie es in der Figur 3 ersichtlich ist; der Emitter des Transistors 34 schliesst sich an den O-Punkt des gemeinsamen Potentials des Stromkreises an; der Widerstand 35 des Kollektorkreises ist an den gemeinsamen Punkt 3a der Impedanz 3 des Emitterkreises angeschlossen, während die Steuerklemme 3d des Widerstands 32 von der Basis des Transistors 34 gebildet ist.

Auch die obenbeschriebene Ausführung bestätigt die bei allen Versionen des erfindungsgemässen Verstärkerstromkreises auftretende charakteristische Wirkung: das aktive Element nimmt nur soviel Energie aus dem Speisestromkreis auf, wie zur Erzeugung der abzugebenden Leistung erforderlich ist. Das aktive Element zugrundegelegt kann der Wirkungsgrad des Systems auch 80% erreichen, was bei der Realisierung der Pegelregelung als hervorragender Wert betrachtet werden kann. Der Pegel der Ausgangsspannung $U_{ki}$ hängt lediglich von dem Pegel des in dem Referenzgeber 4 eingestellten Grundsignals ab, so dass er von der Speisespannung des Verstärkers praktisch unabhängig ist. So besteht die Notwendigkeit der Stabilisierung der Speisespannung nicht, wodurch eine bedeutende Ersparung erreicht werden kann. Bei den Einfrequenz-Leistungsverstärkern sind die Transistoren im allgemeinen recht empfindlich gegenüber dem äusseren Kurzschluss; daher muss entweder ein begrenzender Widerstand verwendet werden (zusätzlicher Verlust!), oder ein separater Kurzschlussschutz ist erforderlich. In beiden Fällen nimmt der Wirkungsgrad ab. In dem erfindungsgemässen Stromkreis wird der Überstromschutz, falls der Stromgenerator nach Figur 3 ausgestaltet ist, durch den Widerstand 35 des Kollektorkreises des Transistors 34 sichergestellt. Die Speisestromgrenze kann durch dem Fachmann wohlbekannte Dimensionierungsüberlegungen eingestellt werden. Diese Begrenzung ist auch dann wirksam, wenn keine Eingangsspannung $U_{be}$ vorhanden ist.

In dem erfindungsgemässen Stromkreis wird der Frequenzbereich ausschliesslich durch die Grenzfrequenz des Transistors beschränkt, daher kann der erfindungsgemässe Stromkreis mit einem entsprechend gewählten Transistor des herkömmlichen Bereiches der Frequenzunabhängigkeit der passiven Elemente, d. h. bis mehrhunderten MHz, in dem in der Figur 1 veranschaulichten Grundaufbau verwendet werden.

Wenn nun der Pegel des Grundsignals konstant ist, was die Zenerdiode 43 mit befriedigender Zuverlässigkeit sicherstellt, wird der Pegel der Ausgangsspannung $U_{ki}$ des Verstärkerstromkreises auch dann stabil bleiben, wenn die dynamischen Parameter des aktiven Elementes, d. h. des Transistors 2 und der sonstigen Schaltungselemente, sich ändern. Daher ist der erfindungsgemässe Stromkreis weitgehend temperaturunabhängig.

Für den Fachmann ist es offensichtlich, dass der erfindungsgemässe Stromkreis mit diskreten Elementen wie auch mit dick- bzw. dünnschichtiger integrierter Technologie ausgestaltet werden kann. Der Aufbau ist einfach, der Stromkreis enthält wenige Stromkreiselemente, so ist der Stromkreis zuverlässig und billig.

Selbstverständlich kann der Referenzgeber mit einem fixen Ausgangspegel realisiert werden. Im allgemeinen aber scheint es zweckmässig, wenn der Ausgangspegel des Verstärkerstromkreises durch die Modifizierung des Grundsignals geändert werden kann, so z. B. durch die Änderung des Teilungsverhältnisses des Niederstrom-Spannungsteilers. Es ist weiterhin als vorteilhaft zu betrachten, wenn das zur Pegeleinstellung dienende Element, z. B. ein Potentiometer, von dem Hochfrequenz-Verstärker ‹fern› liegt, da mit dem Potentiometer das Gleichstromsignal geregelt wird. In diesem Fall folgt der Pegel der Ausgangsspannung $U_{ki}$ zwischen weiten Grenzen und linear dem Grundsighal. Eine annähernd rechteckige Übertragungscharakteristik kann erreicht werden, falls die Änderung der Signalfrequenz mit einer niedrigeren Geschwindigkeit vor sich geht, als die aus der Zeitkonstante berechnete Geschwindigkeit. Durch die Anwendung eines einzigen Schwingungskreises kann eine Charakteristik ausgestaltet werden, zu der beim Stand der Technik mehrere Schwingungskreise erforderlich sind. In dem erfindungsgemässen frequenzselektiven Stromkreis können auch solche Schwingungskreise mit einer geringen Bandbreite verwendet werden, die in den herkömmlichen Schaltungsanordnungen zu diesem Zweck infolge ihrer Instabilität nicht verwendet werden konnten. Die Frequenzabhängigkeit des Verstärkerstromkreises mit Transistor und Abstimmstromkreis kann dank der erfindungsgemässen Wirkungsweise zwischen weiten Grenzen geregelt werden, wodurch mit den Schwingungskreisen mit Schmalband eine äusserst hochgradige Signalreinheit erreicht werden kann, die durch die Kettenschaltung von mehreren Stufen noch weiter erhöht werden kann.

Bei den günstigen Betriebseigenschaften des erfindungsgemässen Stromkreises spielt die Tatsache eine grosse Rolle, dass der Verstärker aus der an seinem Eingang ankommenden Steuerenergie jeweils eine annähernd gleiche Teilmenge verwertet, da der Verstärker nur innerhalb der zur Erzeugung der Ausgangsleistung erforderlichen Zeitspanne mit einem aktiven Eingang arbeitet, ansonsten aber unterbrochen ist. Daraus folgt, dass eine Zunahme des Pegels der Eingangsspannung $U_{be}$, sogar um mehrere Grössenordnungen, keineswegs zu einer Übersteuerung führen kann. Die Schmalband-Übertragungsfähigkeit und die wirksame Amplitudenregelung ergeben zusammen den Erfolg, indem die Amplitude und Signalreinheit des Ausgangssignals jedwelcher Stufe binnen weiten Grenzen von dem Pegel und der Form der Eingangsspannung $U_{be}$ unabhängig sind.

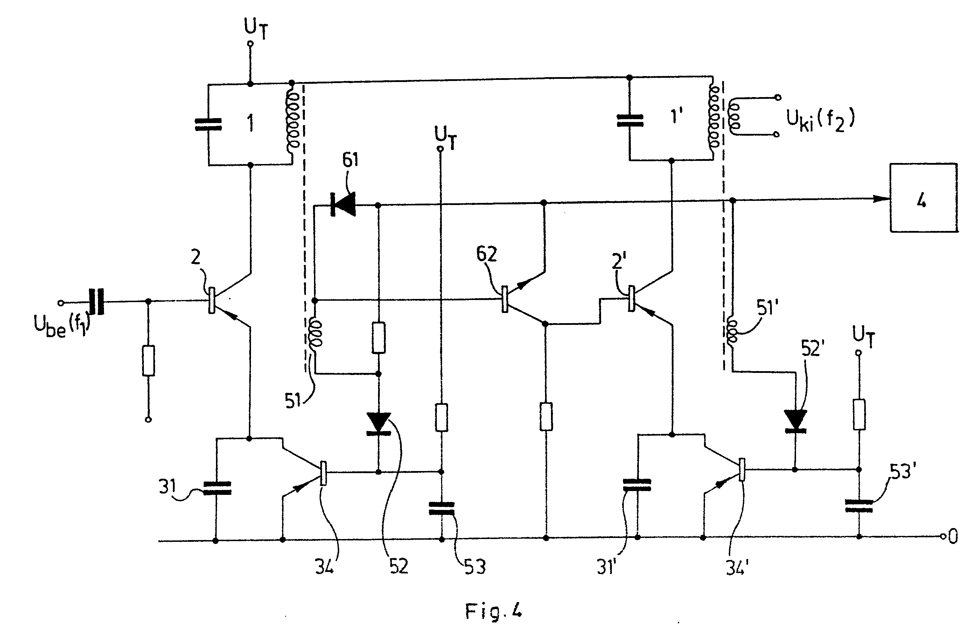

In der Figur 4 ist eine Schaltungsanordnung mit einem Spannungsmultiplexer dargestellt, in der zwei erfindungsgemässe Verstärkungsstufen in Reihe geschaltet sind. Bei beiden Stufen wird die in der Figur 1 gezeigte grundsätzliche Anordnung realisiert; die übereinstimmenden Elemente der Schaltungsanordnung wurden übereinstimmend bezeichnet, jedoch mit dem Unterschied, dass bei der zweiten Stufe alle Positionnummern mit einem Komma versehen sind. Die Anpassung zwischen den beiden Stufen wird von der Diode 61 und dem Trenntransistor 62 sichergestellt. Aus der Spannung $U_{be}$ mit der Frequenz $f_1$ wird an dem Ausgang der zweiten Stufe eine Spannung $U_{ki}$ mit der Frequenz $f_2$ gewonnen, wobei $f_2$ ein ganzes Vielfaches der Frequenz $f_1$ darstellt. Das Bandfilter 1 der ersten Stufe kann auf die Frequenz $f_2$ oder z.B. auf eine Frequenz $f_k$ abgestimmt werden, die ebenfalls ein ganzes Vielfaches der Frequenz $f_1$ darstellt und für die $f_1 < f_k < f_2$ gilt. Die Zahl der Stufen kann erhöht werden; bei einer fixen Frequenz kann in einer Stufe die Signalfrequenz auf das 2- bis 100-Fache erhöht werden.

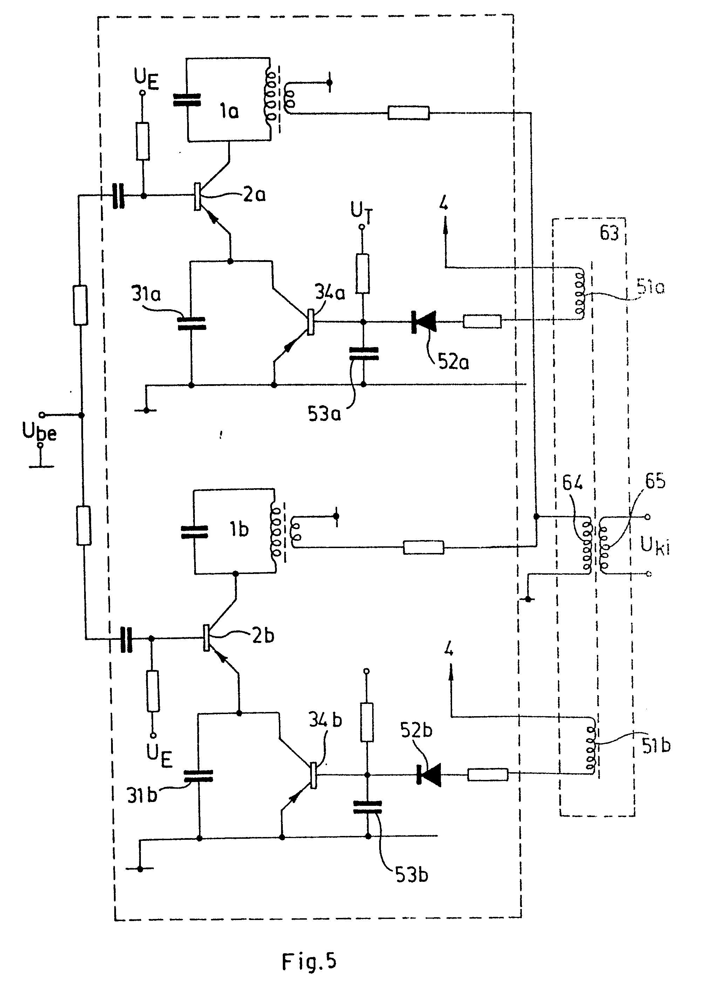

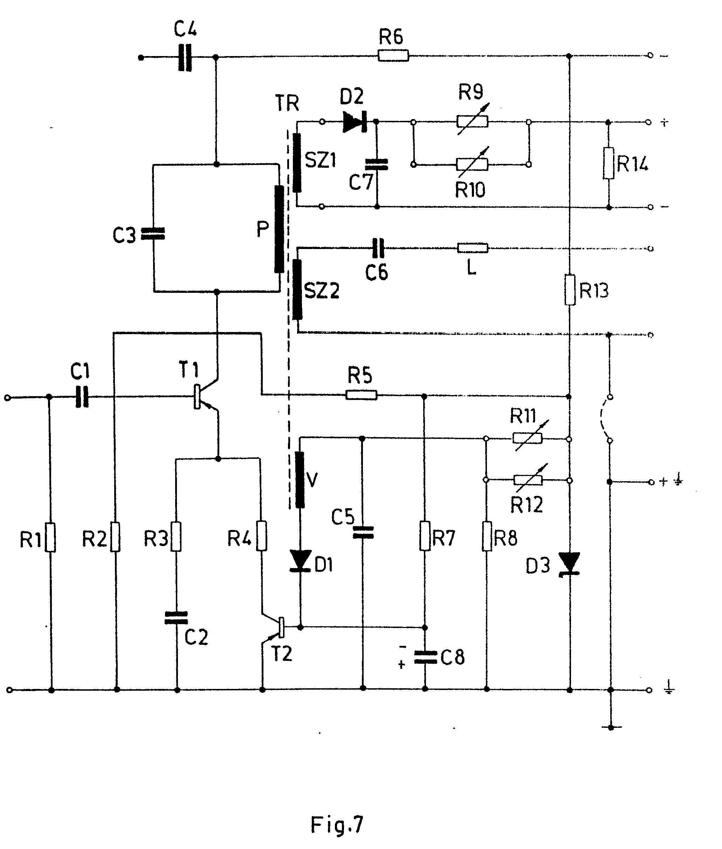

Die in der Figur 5 dargestellte Schaltungsanordnung ist ein zur Erhöhung der Zuverlässigkeit dienender Redundanzstromkreis. Bei den beiden parallel funktionierenden erfindungsgemässen Stufen werden die übereinstimmenden funktionellen Elemente übereinstimmend, aber mit einem unterscheidenden Index ‹a› bzw. ‹b› bezeichnet. Die Eingangsspannung $U_{be}$ wird an den gemeinsamen Eingang der beiden Stufen gelegt. Bei der als Beispiel dienenden Anordnung liegt z.B. die Vorspannung $U_E$ der basisableitenden Widerstände der Transistoren 2a und 2b über 1 V. Die mit den induktiven Wicklungen der beiden Bandfilter 1a und 1b gekoppelten Entkoppelungswicklungen sind gemeinsam an die Primärwicklung 64 des Transformators 63 angeschlossen, während die Sekundärwicklung 65 des Transformators 63 den Ausgang des Transformators 63 bildet und die weiteren beiden Wicklungen des Transformators 63 die Leitsignalgeber 51a und 51b der einen bzw. der anderen Stufe bilden.

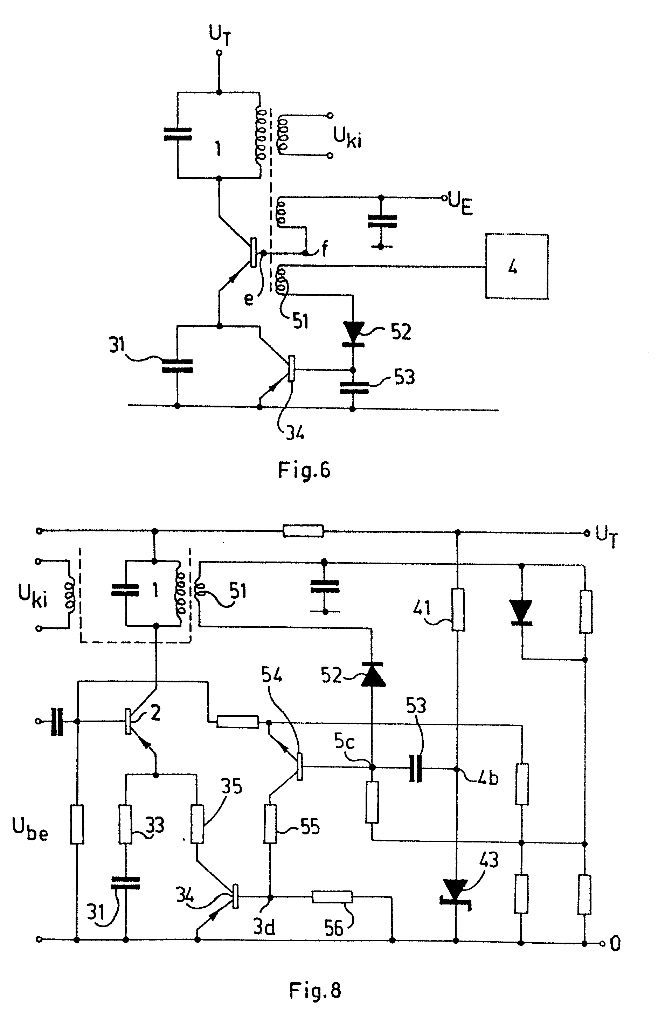

Aus der Figur 6 geht hervor, dass zwischen den Ausgang und den Eingang des erfindungsgemässen, gemäss Figur 1 ausgestalteten Verstärkerstromkreisen ein positiver, der Einheitsschleifenverstärkung entsprechender Rückkoppelungszweig geschaltet ist. Die eine Klemme der weiteren mit der induktiven Wicklung des Bandfilters 1 gekoppelten Wicklung ist an das die Vorspannung $U_E$ der Basis sicherstellende Potential angeschlossen (die Vorspannung $U_E$ stellt den zu der Einschwingung erforderlichen Startarbeitspunkt ein), während die andere Klemme in diesem Sinne den Ausgangspunkt 2f des Verstärkerstromkreises repräsentiert, der bei unserem Beispiel mit einem Kurzschluss über den Eingang des Verstärkerstromkreises repräsentierenden Punkt 2e der Basis des Transistors 2 angeschlossen ist. Wird nun in den Kurzschluss zwischen den Punkten 2e und 2f ein Schwingquarzkristall eingesetzt,

wird ein quartzstabilisierter LC-Oszillator erhalten.

In Figur 7 ist das Schaltbild eines bereits serienmässig hergestellten erfindungsgemässen pegelbegrenzenden Stromkreises dargestellt, mit dem innerhalb einer engen Toleranz und mit hoher Signalreinheit eine alternierende Ausgangsspannung mit einem Pegel $U_{ki}$ = O dBu/75 Ohm und eine Gleichspannung mit einem Pegel von 10V/ 100 kOhm durch die Verarbeitung eines alternierenden Eingangsspannungssignals, dessen spezifizierter Bereich zwischen $-17,37$ dBu $+8,69$ dBu liegt, erreicht werden können.

Bei diesem Ausführungsbeispiel ist die induktive Wicklung des Bandfilters 1 durch die Primärwicklung P des Transformators TR gebildet, mit der die erste Sekundärwicklung SZ1, die zweite Sekundärwicklung SZ2 und die weitere induktive Wicklung gekoppelt sind, wobei die letztere den Leitsignalgeber V darstellt. Das der zweiten Sekundärwicklung SZ2 in Reihe nachgeschaltete Bandfilter sichert im Hinblick auf die Reinheit des Ausgangssignals mit alternierender Spannung eine weitere Verbesserung von 30 dB (L = 1 mH).

Die Liste der in der Schaltungsanordnung nach Figur 7 verwendeten Elemente ist in der Tabelle 2 zusammengestellt. Die Übersetzungen des Transformators TR ist durch die Angabe der Windungszahl veranschaulicht: die Wicklung P weist achtzehn, die Wicklung SZ1 sechzehn, die Wicklung SZ2 1,5 und die Wicklung des Leitsignalgebers V sieben Gänge auf. Die Nominalinduktivität der Wicklung P beträgt bei 100 kHz 21,7 µH, die Güte bei 300 kHz gemessen Q ≥ 130.

Wir haben bei zwei Betriebsfrequenzen (300 bzw. 308 kHz) die $U_{ki}$ Spannung des mit der ersten Sekundärwicklung SZ1 gekoppelten Gleichstromausgangs – die alternierende Eingangsspannung $U_{be}$ innerhalb des für den Verstärkerstromkreis spezifizierten Bereichs ändernd – gemessen und haben im Vergleich zu der Grundharmonischen die Dämpfungen $A_{k2}$ bzw $A_{k3}$ der zweiten bzw. dritten Harmonischen bestimmt. Die Ergebnisse sind in der Tabelle 1 zusammengefasst.

Die Güte der Regelung kann weiter erhöht werden, wenn das Differenzsignal verstärkt auf die Steuerklemme 3d des spannungsgesteuerten Widerstands 32 angelegt wird. Eine solche Ausführungsform ist in der Figur 8 dargestellt. Die Bezugsbezeichnungen wurden nur in einem zur Verständlichkeit erforderlichen Masse angeführt. Die Einfügung der zusätzlichen Verstärkerstufe erhöht nur geringfügig die Zahl und Kompliziertheit der in der Schaltungsanordnung vorhandenen Elemente, da die dynamischen Gegebenheiten des erfindungsgemässen Stromkreises ausgenutzt werden: die Wechselstrom-Potentialverhältnisse bleiben unverändert, hingegen wird der Sohlenpunkt des Komparatorzweiges nicht dem Gleichstrompunkt mit dem gemeinsamen Potential angeschlossen. An den Ausgang 4b des Referenzgebers 4 schliesst sich der Kondensator 53 an, wobei die gemeinsame Klemme 5c des Kondensators 53 und des Widerstands 52 mit Ventilwirkung über einen weiteren Transistor 54 an der Klemme 3d

Tabelle 1

| $U_{be}$ /dBu/ | $U_{ki}$ /V/ | 300 kHZ | | $U_{ki}$ /V/ | 308 kHz | |
| | | Dämpfung | | | Dämpfung | |
| | | $A_{k2}$ /dBr/ | $A_{k3}$ /dBr/ | | $A_{k2}$ /dBr/ | $A_{k3}$ /dBr/ |
|---|---|---|---|---|---|---|
| − 17,32 | 9,94 | 79,91 | 84,25 | 9,93 | 80,78 | 84,69 |
| − 8,69 | 9,99 | 95,54 | 84,25 | 9,99 | 96,41 | 84,69 |
| 0 | 9,97 | 82,52 | 84,52 | 9,98 | 81,82 | 84,69 |
| + 8,69 | 9,95 | 79,91 | 81,65 | 9,96 | 80,78 | 82,52 |

Tabelle 2

| R1 | 75 Ohm ± 2% 1/8 W | R2 | 13 kOhm ± 5% 1/8 W |
|---|---|---|---|
| R3 | 18 Ohm ± 5% 1/8 W | R4 | 100 Ohm ± 5% 1/8 W |
| R5 | 27 kOhm ± 5% 1/8 W | R6 | 220 Ohm ± 5% 1/8 W |
| R7 | 68 kOhm ± 5% 1/8 W | R8 | 5,1 kOhm ± 5% 1/8 W |
| R13 | 2,2 kOhm ± 5% 0,25 W | R14 | 10 kOhm ± 5% 1/8 W |
| R9, R10 | 1,54 ÷ 5,11 kOhm | R11, R12 | 1,87 ÷ 4,22 kOhm |
| CI, C2 | 150 nF ± 20% 100 V | C, 5 C7 | 150 nF ± 20% 100 V |
| C3 | 13 nF ± 1% 63 V | C4 | 10 µF 25 V |
| C6 | 280 pF ± 1% 63 V | C8 | 6,8 µF 6 V |
| D1, D2 | 1N 4148 | D3 | ZPD 6,8 |
| TI | 2N 2905 A | T2 | BCY 78 VII |

des spannungsgesteuerten Widerstands 32 liegt. Bei der geschilderten Ausführung ist die Basis des weiteren Transistors 54 an die gemeinsame Klemme 5c angeschlossen, während die Klemme 3d des spannungsgesteuerten Widerstands 32 mit der Abzweigung der von den Widerständen 55 und 56 erzeugten Kollektorimpedanz verbunden ist.

Bei einem auf eine Betriebsfrequenz von 100 kHz eingestellten und auf einen auf den Eingangspegel von − 6 dBu bezogenen Nominalausgangspegel von 0 dBu ausgestalteten Verstärker beträgt innerhalb des Temperaturbereichs zwischen + 6 C° und − 20 C° bei einer Änderung des Eingangspegels − 18dBu ÷ 0 dBu die Schwankung des Ausgangspegels insgesamt + 0,01$_{dB}$ bis − 0,3.

## Patentansprüche

1. Aus einer oder mehreren Stufen bestehender, frequenzselektiver, geregelter, elektronischer Verstärkerstromkreis, dessen Ausgang je Stufe von dem Ausgang eines in den Kollektorkreis eines Transistors (2) geschalteten Bandfilters (1) gebildet ist, während das Regelorgan je Stufe mit der Impedanz (3) des Emitterkreises des Transistors (2) gekoppelt ist, wobei die Impedanz (3) des Emitterkreises ein frequenzabhängiges Element enthält, das mit einem spannungsgesteuerten Widerstand (32) parallelgeschaltet ist, dadurch gekennzeichnet, dass das frequenzabhängige Element ein bei Nullfrequenz einen Pol aufweisendes Glied, vorzugsweise ein Kondensator oder ein in Reihe geschaltetes RC-Glied ist, dass der Stromkreis einen Referenzgeber (4) und einen Vergleicherzweig enthält, in dem ein mit dem Ausgang des Bandfilters (1) gekoppelter Signalgeber (51), ein Ventilwirkung entfaltender Widerstand (52) und ein Kondensator (53) in Reihe geschaltet sind, wobei die eine Klemme des Vergleicherzweiges an den Ausgang (4b) des Referenzgebers (4) angeschlossen ist, während die gemeinsame Klemme des Widerstandes (52) und des Kondensators (53) an die Steuerklemme (3d) des spannungsgesteuerten Widerstandes (32) angeschlossen ist.

2. Verstärkerstromkreis nach Anspruch 1, dadurch gekennzeichnet, dass der spannungsgesteuerte Widerstand (32) ein Stromgenerator mit einem mit Spannung steuerbaren Arbeitspunkt ist.

3. Verstärkerstromkreis nach Anspruch 2, dadurch gekennzeichnet, dass als spannungsgesteuerter Widerstand (32) der Emitter-Kollektorstromkreis eines weiteren Transistors (34) in den Emitterkreis des Transistors (2) eingesetzt ist, wobei die Basis dieses weiteren Transistors (34) die Steuerklemme (3d) bildet.

4. Verstärkerstromkreis nach Anspruch 3, dadurch gekennzeichnet, dass der Kollektorstromkreis des weiteren Transistors (34) einen Widerstand (35) enthält.

5. Verstärkerstromkreis nach einem der Ansprüche 1–4, dadurch gekennzeichnet, dass der Referenzgeber (4) einerseits von einem zwischen den Klemmen der Speisespannungsquelle eingeschalteten Stromkreiszweig, der die Reihenschaltung eines Widerstandes (41) und eines spannungsstabilisierenden Elements, vorzugsweise einer Zener-Diode (43) enthält, andererseits von einem mit dem spannungsstabilisierenden Element parallelgeschalteten Spannungsteiler (42) mit veränderlichem Teilungsverhältnis gebildet wird, und dass die Abzweigung des Spannungsteilers (42) den Ausgang (4b) des Referenzgebers (4) bildet.

6. Verstärkerstromkreis nach einem der Ansprüche 1–4, dadurch gekennzeichnet, dass der Referenzgeber (4) über ein zur periodischen Änderung des Ausgangspegels geeignetes Mittel verfügt, dessen Stellfrequenz (f$_m$) wenigstens um drei Grössenordnungen kleiner ist als die niedrigste Betriebsfrequenz (f$_a$) des Verstärkers, d.h.

$$f_m \leq 10^{-3} \times f_a.$$

7. Verstärkerstromkreis nach einem der Ansprüche 1–6, dadurch gekennzeichnet, dass der Ausgang des Bandfilters (1) induktiv gekoppelt ist und der Signalgeber (51) durch eine mit dem Ausgang gekoppelte induktive Wicklung gebildet ist.

8. Verstärkerstromkreis nach einem der Ansprüche 1–5, dadurch gekennzeichnet, dass er aus zwei oder mehreren Stufen besteht, wobei in jeder höheren Stufe die Betriebsfrequenz (f$_2$) des Bandfilters (1') einem ganzen Vielfachen der Betriebsfrequenz (f$_1$) des Bandfilters (1) der ersten Stufe gleich ist.

9. Verstärkerstromkreis nach Anspruch 8, dadurch gekennzeichnet, dass zwischen den Stufen eine galvanische Kopplung vorhanden ist.

10. Verstärkerstromkreis nach einem der Ansprüche 1–6, dadurch gekennzeichnet, dass zwischen dem Eingang und dem Ausgang einer Stufe des Stromkreises ein positiver, der Einheitsschleifenverstärkung entsprechender Rückkopplungszweig geschaltet ist.

11. Verstärkerstromkreis nach Anspruch 10, dadurch gekennzeichnet, dass in den Rückkopplungszweig ein frequenzstabilisierendes Element, zweckmässigerweise ein Schwingquartzkristall, eingebaut ist.

12. Verstärkerstromkreis nach einem der Ansprüche 1–6, dadurch gekennzeichnet, dass zwei parallele Stufen vorgesehen sind, deren gemeinsamer Eingang den Signaleingang des Stromkreises bildet, während der gemeinsame Ausgang der beiden Bandfilter (1a und 1b) an die Primärwicklung (64) des Transformators (63) angeschlossen ist, wobei die Sekundärwicklung (65) des Transformators (63) den Ausgang des Verstärkerstromkreises bildet, und die weiteren beiden gleichermassen ausgestalteten Wicklungen des Transformators (63) den Signalgeber (51a und 51b) der einen bzw. der anderen Stufe bilden.

13. Verstärkerstromkreis nach einem der Ansprüche 1–6, dadurch gekennzeichnet, dass wenigstens ein Bandfilter (1) mit einem frequenzstabilisierenden Element, vorzugsweise einem Filterquartzkristall, ausgestattet ist.

14. Verstärkerstromkreis nach Anspruch 1, dadurch gekennzeichnet, dass der Kondensator (53) an den Ausgang (4b) des Referenzgebers (4) angeschlossen ist und die gemeinsame Klemme (5c) des Kondensators (53) und des Ventilwirkung entfaltenden Widerstandes (52) über einen weiteren Transistor (54) an die Steuerklemme (3d) des spannungsgesteuerten Widerstandes (32) geführt ist.

**Claims**

1. Frequency selective, controlled, electronic amplifier circuit consisting of one or several stages and having an output for each stage which is provided by the output of a band filter (1) connected to the collector circuit of a transistor (2), whereas the controlling means of each stage is connected to the impedance (3) of the emitter of the transistor (2), which impedance (3) of the emitter circuit contains a frequency dependent element which is connected in parallel to a resistor (32) controlled by voltage, characterized in that the frequency dependent element is a member, preferably a capacitor or an in series connected RC-member, that the circuit is provided with a reference transmitter (4) and a comparing branch, in which a signal transmitter (51) connected to the output of the band filter (1), a resistor (52) with valve effect and a condenser (53) are connected in series, wherein the one end of the comparing branch is connected to the output (4b) of the reference transmitter (4), whereas the shared end of the resistor (52) and the condenser (53) is connected to the controlling end (3d) of the voltage controlled resistor (32).

2. Amplifier circuit according to claim 1, characterized in that the voltage controlled resistor (32) is a current generator provided with an operating point controllable by voltage.

3. Amplifier circuit according to claim 2, characterized in that the voltage controlling resistor (32) of the emitter collector circuit of a further transistor (34) within the emitter circuit of the transistor (2) is used, the base of that further transistor (34) is provided by the controlling end (3d).

4. Amplifier circuit according to claim 3, characterized in that the collector circuit of that further transistor (34) includes a resistor (35).

5. Amplifier circuit according to one of the claims 1–4, characterized in that the reference transmitter (4) is provided on the one hand by a circuit branch included between the terminals of the voltage source and containing the circuit in series of a resistor (41) and a voltage stabilizing element, preferably of a Zener diode (43), and on the other hand by a voltage divider connected in parallel to that voltage stabilizing element and being provided with a changeable dividing ratio, the branch of that voltage divider (42) forming the output (4b) of the reference transmitter (4).

6. Amplifier circuit according to one of the claims 1–4, characterized in that the reference transmitter (4) is provided with means for periodically changing the output level, the control frequency (f$_m$) of which is at least 1000 times greater than the lowest frequency (f$_a$) of the amplifier, i.e.,

$$f_m \leq 10^{-3} \times f_a.$$

7. Amplifier circuit according to one of the claims 1–6, characterized in that the output of the band filter (1) is inductively coupled and that the signal transmitter (51) is formed by an inductive reactance coupled to that output.

8. Amplifier circuit according to one of the claims 1–5, characterized in that it consists of two or more stages, wherein in each higher stage the operation frequency ($f_2$) of the band filter (1′) is equal to an even multiple of the operation frequency ($f_1$) of the band filter (1) of the first stage.

9. Amplifier circuit according to claim 8, characterized in that the stages are DC coupled.

10. Amplifier circuit according to one of the claims 1–6, characterized in that between the input and the output of the stage of the circuit a feedback branch is connected corresponding to the amplification of the unit loup gain.

11. Amplifier circuit according to claim 10, characterized in that preferably a quartz resonator is built in the feedback branch as a frequency stabilizing element.

12. Amplifier circuit according to one of the claims 1–6, characterized in that two parallel stages are provided, the shared input of which is forming the signal input of the circuit, whereas the shared output of the two band filters (1a and 1b) is connected to the primary winding (64) of the transformer (63), the secondary winding (65) of that transformer (63) forming the output of the amplifier circuit and that the further two windings of the transformer (63) which are similarly configured form the signal transmitter (51a and 51b) of the one or the other stage, respectively.

13. Amplifier circuit according to one of the claims 1–6, characterized in that at least one band filter (1) is provided with a frequency stabilizing element, preferably a filter quartz crystal.

14. Amplifier circuit according to claim 1, characterized in that the condenser (53) is connected to the output (4b) of the reference transmitter (4) and that a common terminal (5c) of the condenser (53) and the resistor (52) operating with valve effect are connected through a further transistor (54) to the control terminal (3d) of the voltage controlling resistor (32).

**Revendications**

1. Circuit électronique régulé d'amplification à sélection de fréquence comportant un ou plusieurs étages et dont la sortie est constituée pour chaque étage, par la sortie d'un filtre passe-bande (1) branché dans le circuit du collecteur d'un transistor (2), l'organe de régulation étant couplé, pour chaque étage, à l'impédance (3) du circuit de l'émetteur du transistor (2), tandis que l'impédance (3) du circuit de l'émetteur comporte un élément sensible à la fréquence qui est branché en parallèle avec une résistance (32) réglée en fonction de la tension, caractérisé en ce que l'élément sensible à la fréquence est un organe présentant un pôle pour la fréquence zéro et constitué, de préférence, par un condensateur ou un composant RC branché en série, en ce que ledit circuit comporte un générateur de référence (4) et une branche de comparaison comprenant, en série, un générateur de signaux (51) couplé à la sortie du filtre passe-bande (1), une résistance (52) faisant fonction de valve, ainsi qu'un condensateur (53), l'une des bornes de la branche de comparaison étant reliée à la sortie (4b) du générateur de référence (4) tandis que la borne commune à la résistance (52) et au condensateur (53) est reliée à la borne de commande (3d) de la résistance sensible à la tension (32).

2. Circuit d'amplification selon la revendication 1, caractérisé en ce que la résistance (32) sensible à la tension est constituée par un générateur de courant présentant un point de fonctionnement réglable en fonction de la tension.

3. Circuit d'amplification selon la revendication 2, caractérisé en ce que ladite résistance sensible à la tension (32) est constituée par le circuit d'émetteur et de collecteur d'un second transistor (34), qui est branché dans le circuit émetteur du transistor (2) la base dudit second transistor (34) faisant fonction de borne de commande (3d).

4. Circuit d'amplification selon la revendication 3, caractérisé en ce que le circuit de l'émetteur de l'autre transistor (34) comporte une résistance (35).

5. Circuit d'amplification selon l'une des revendications 1 à 4, caractérisé en ce que le générateur de référence (4) est constitué, d'une part, par une branche de circuit montée entre les bornes de la source d'alimentation en tension et comportant, en série, une résistance (41) et un élément stabilisateur de tension formé, de préférence, d'une diode Zener (43) et, d'autre part, par un diviseur de tension (42) à rapport de division variable, qui est branché en parallèle avec ledit élément stabilisateur de tension, et en ce que la dérivation du diviseur de tension (42) constitue la sortie (4b) du générateur de référence (4).

6. Circuit d'amplification selon l'une des revendications 1 à 4, caractérisé en ce que ledit générateur de référence (4) comporte un moyen propre à assurer des variations périodiques du niveau de sortie et dont la fréquence d'ajustage ($f_m$) est inférieure d'au moins trois ordres de grandeur à la fréquence de service minimum ($f_a$) de l'amplificateur, soit:

$$f_m \leq 10^{-3} \times f_a$$

7. Circuit d'amplification selon l'une des revendications 1 à 6, caractérisé en ce que la sortie du filtre passe-bande (1) est couplé inductivement et que le générateur de signaux (51) est constitué par un enroulement inductif couplé à la sortie précitée.

8. Circuit d'amplification selon l'une des revendications 1 à 5, caractérisé en ce qu'il est constitué par deux étages ou plus, cependant que la fréquence de régime ($f_2$) du filtre passe-bande (1′) est égale, dans chaque étage supérieur, à un multiple entier de la fréquence de service ($f_1$) du filtre passe-bande du premier étage.

9. Circuit d'amplification selon la revendication 8, caractérisé en ce qu'un couplage galvanique est prévu entre les étages.

10. Circuit d'amplification selon l'une des revendications 1 à 6, caractérisé en ce qu'une branche de réaction positive correspondant à l'amplification de boucle unitaire est montée entre l'entrée et la sortie d'un étage du circuit.

11. Circuit d'amplification selon la revendication 10, caractérisé en ce qu'un élément stabilisateur de fréquence, tel qu'un cristal de quartz oscillant est branché dans la branche de réaction.

12. Circuit d'amplification selon l'une des revendications 1 à 6, caractérisé en ce qu'il est prévu deux étages parallèles dont l'entrée commune constitue l'entrée de signaux du circuit, la sortie commune des deux filtres passe-bande (1a et 1b) étant reliée à l'enroulement primaire (64) du transformateur (63), tandis que l'enroulement secondaire (65) du transformateur (63) constitue la sortie du circuit amplificateur et que les deux autres enroulements du transformateur (63) agencés de la même façon constituent le générateur de signaux (51a et 51b) de l'un et de l'autre étage, respectivement.

13. Circuit d'amplification selon l'une des revendications 1 à 6, caractérisé en ce qu'au moins un filtre passe-bande (1) est pourvu d'un élément stabilisateur de fréquence, constitué, de préférence, par un cristal de quartz formant filtre.

14. Circuit d'amplification selon la revendication 1, caractérisé en ce que le condensateur (53) est relié à la sortie (4b) du générateur de référence (4), cependant que la borne commune (5c) au condensateur (53) est à la résistance (52) faisant fonction de valve est reliée à la borne de commande (3d) de la résistance sensible à la tension (32), par l'intermédiaire d'un autre transistor (54).

Fig.1

Fig.2

Fig.3

Fig.4

Fig.5

Fig.7

Fig.6

Fig.8

19